# EUROPÄISCHE PATENTSCHRIFT

(11) **EP 0 630 525 B1**
(45) Veröffentlichungstag und Bekanntmachung des Hinweises auf die Patenterteilung: **30.08.2006**
(21) Anmeldenummer: 93905179.3
(22) Anmeldetag: 10.03.1993
(51) Int. Cl.: H01L 31/0224, H01L 31/18

(54) **Herstellungsverfahren einer Solarzelle mit kombinierter Metallisierung**
Process for producing a solar cell with combined metallization
Procédé de fabrication d'une cellule solaire avec metallization combinée

(30) Priorität: 20.03.1992 DE 4209170
(43) Veröffentlichungstag der Anmeldung: 28.12.1994
(73) Patentinhaber: Shell Solar GmbH, 81739 München (DE)
(72) Erfinder: HOLDERMANN, Konstantin, D-89362 Offingen (DE); MÜNZER, Adolf, D-85716 Unterschleissheim (DE); SCHMIDT, Hans-Josef, Dr., D-81825 München (DE)
(74) Vertreter: Zeestraten, Albertus W. J.
(86) Internationale Anmeldenummer: PCT/DE1993/000223
(87) Internationale Veröffentlichungsnummer: WO 1993/019492

(56) Entgegenhaltungen:
- EP-A- 0 156 366
- WO-A-89/00342
- WO-A-91/08584
- US-A- 4 321 283
- M. A. GREEN 'HIGH EFFICIENCY SILICON SOLAR CELL' 1987 , TRANS TECH PUBLICATIONS , SWITZERLAND
- SOLAR CELLS. Bd. 15, Nr. 1, September 1985, LAUSANNE CH Seiten 1 - 25 G. C. DUBEY 'Application of thick film techniques to the manufacture of solar cells'
- 13TH IEEE PHOTOVOLTAIC SPECIALISTS CONFERENCE 5. Juni 1978, WASHINGTON, D.C., USA Seiten 597 - 602 M.G. COLEMAN ET AL. 'The Pd2Si-(Pd)-Ni solder plated metallization system for silicon solar cells'

## Beschreibung

Hocheffiziente Solarzellen aus poly- oder monokristallinem Halbleitermaterial, zum Beispiel aus Silizium, müssen in allen Details auf einen hohen Wirkungsgrad hin optimiert sein. So werden zum Beispiel Wafer verwendet, die eine nur schwache Dotierung aufweisen und daher eine niedrige Defektdichte besitzen. Der pn-Übergang wird an der Vorder- oder Lichteinfallsseite zum Beispiel durch Eindiffusion von Phosphor erzeugt, wobei die so geschaffene hoch dotierte Zone nur eine geringe Tiefe besitzt.

Zur Verbesserung der Stromableitung an der Rückseite der Solarzelle wird die Dotierung direkt unter dem Rückseitenkontakt erhöht. Üblicherweise wird dazu Aluminium verwendet, das zum Beispiel durch Aufdampfen oder in anderer Art und Weise auf der Rückseite aufgebracht und eindiffundiert wird.

Zur Metallisierung der Solarzellen bzw. zur Herstellung der stromableitenden Kontakte sind verschiedene Methoden und Verfahren bekannt. In einfacher Weise kann eine strukturierte Metallisierung durch Aufdrucken hergestellt werden. In einem Siebdruckverfahren unter Verwendung einer elektrisch leitenden, Metallpartikel enthaltenden Paste können beliebige Elektrodenstrukturen erzeugt werden. Metallisierungen können durch Aufdampfen von dünnen Metallschichten erzeugt und in einem weiteren Schritt verstärkt werden, zum Beispiel durch Tauchbeloten, galvanische Abscheidung oder stromlose chemische Abscheidung. Auf entsprechend vorbereiteten Oberflächen ist es auch möglich, die Metallisierung durch chemische Abscheidung direkt auf der Halbleiteroberfläche zu erzeugen.

Mit Siebdruck aufgebrachte Vorderseitenkontakte können nur in Strukturbreiten bis minimal ca. 80 µm realisiert werden. Zur weiteren Leistungssteigerung der Solarzellen sind feinere Strukturen für den Vorderseitenkontakt erforderlich, um die dadurch bedingten Abschattungen aktiver Solarzellenoberflächen zu verringern.

Aus der WO-A-91 08 584 ist ein Verfahren zur Herstellung einer Punktkontaktsolarzelle bekannt, bei dem für den Vorderseitenkontakt ein Muster von mikroskopischen Öffnungen mit Hilfe eines Lasers erzeugt wird. In diesen Öffnungen werden punktförmige Nickelkontakte erzeugt, die durch chemische Abscheidung von Kupfer verstärkt und elektrisch leitend miteinander verbunden werden. Für den Rückseitenkontakt wird eine Aluminiumschicht verwendet, die aufgedampft oder aufgedruckt wird.

Aus der EP-A-15 63 66 ist ein Verfahren zur Herstellung einer Solarzelle mit in Gräben angeordneten Vorderseitenkontakten bekannt, bei dem die Gräben durch Laserschreiben erzeugt werden. Die Vorderseitenkontakte können durch Füllen der Gräben mit elektrisch leitender Paste und anschließendem Einbrennen derselben erzeugt und durch Tauchbeloten verstärkt werden. Alternativ wird der Vorderseitenkontakt durch stromlose Abscheidung von Nickel erzeugt, gesintert und durch Plattieren von Kupfer verstärkt.

Aus Solar Cells, Band 15, Nr. 1, September 1985, Seiten 1 bis 25 ist eine Dickfilmtechnik zur Herstellung von Solarzellenkontakten bekannt. Für den Rückkontakt wird eine silber- und aluminiumhaltige Siebdruckpaste verwendet.

Von M. A. Green: "High efficiency silicon solar cells", Seiten 170-171 ist eine Solarzelle mit texturierter Vorderseite und in Gräben angeordnetem Vorderseitenkontakt bekannt. Vorder- und Rückseitenkontakt können durch simultane stromlose Abscheidung von Nickel und anschließend von Kupfer erzeugt werden.

Aufgabe der vorliegenden Erfindung ist es, ein verbessertes Verfahren zur Herstellung von Vorder- und Rückseitenkontakten von Siliziumsolarzellen anzugeben, welches einfache Erzeugung des Rückseitenkontakts erlaubt und mit dem ein feinstrukturierter und gut haftender Vorderseitenkontakt ohne Schädigung des Rückseitenkontakts erzeugt werden kann.

Diese Aufgabe wird erfindungsgemäß durch ein Verfahren nach Anspruch 1 gelöst. Weitere Ausgestaltungen der Erfindung sind den Unteransprüchen zu entnehmen.

Die erfindungsgemäße hergestellte Solarzelle ist eine sogenannte Hybridkontakt-Solarzelle, bei der unterschiedliche Metallisierungen für Vorder- und Rückseitenkontakt in vorteilhafter Weise kombiniert sind. Durch chemische Abscheidung von Metallen lassen sich feinere Strukturen als mit Siebdruck herstellen, nicht zuletzt auch wegen der höheren spezifischen Leitfähigkeit des reinen Metalls gegenüber einer Siebdruckpaste. Der Rückseitenkontakt ist in bekannter Weise aufgedruckt. Die Strukturbreiten des Rückseitenkontakts spielen keine Rolle, da das Problem der Abschattung hier nicht auftreten kann. Der in der Druckpaste enthaltene zusätzliche Dotierstoff Aluminium diffundiert beim Einbrennen des aufgedruckten Rückseitenkontakts in die aktive Halbleiterschicht der Solarzelle ein, verstärkt dort die Dotierung und erzeugt so einen guten elektrischen Kontakt zwischen Halbleiter und Rückseitenkontakt. Ein zusätzliches Aufbringen und/oder Eindiffundieren von Dotierstoff auf der Rückseite durch Aufdampfen, Aufsprühen oder ähnliche Verfahren entfällt.

In einer weiteren Ausgestaltung der Erfindung ist die Oberfläche der Solarzelle texturiert, beispielsweise durch ein kristallorientiertes Ätzverfahren. Eine solche, pyramidenförmige Erhebungen oder Ausnehmungen aufweisende Oberfläche zeigt eine verringerte Reflexion einfallenden Lichts, bzw. eine höhere Absorption.

Der Vorderseitenkontakt ist in einer Grabenstruktur angeordnet, die in einer als Passivierungsschicht dienenden Nitrid- oder Oxidschicht auf der Vorderseite der Solarzelle ausgebildet ist. Vorzugsweise Können die Gräben bis in die aktive Halbleiterschicht eingebracht sein Dadurch ist die Haftung des Vorderseitenkontakts auch bei feinsten Strukturen gegenüber einer erhaben aufgebrachten Elektrodenstruktur verbessert. In den Gräben auf dem freigelegten Halbleitermaterial gelingt dann eine selektive chemische Abscheidung von Metallen. Diese erfolgt zweistufig, wobei zunächst eine aus Palladium bestehende Keimschicht erzeugt wird, die anschließend durch galvanische oder stromlose Abscheidung verstärkt wird. Dabei kann die Keimschicht eine geschlossene dünne Palladiumschicht oder nur eine Schicht aus einzelnen Palladiumkeimen sein. Neben Palladium besteht der Vorderseitenkontakt zur Verstärkung aus zumindest einem weiteren Metall, welches ausgewählt ist aus Kupfer, Nickel oder Silber. Bei Verwendung von Kupfer als Material für den Vorderseitenkontakt ist eine dünne Diffusionssperrschicht aus einem anderen Metall zwischen Kupfer und Halbleitermaterial erforderlich. Wegen seiner hohen elektrischen Leitfähigkeit ist jedoch Silber zur Verstärkung des Vorderseitenkontakts bevorzugt.

Der Rückseitenkontakt kann ganzflächig aufgebracht sein oder zur Materialersparnis eine zum Beispiel netzartige Struktur aufweisen. Die zum Aufdrucken des Rückseitenkontakts verwendete Paste enthält neben oxidischen Zuschlägen Silberpartikel und als weiteren Dotierstoff Aluminium.

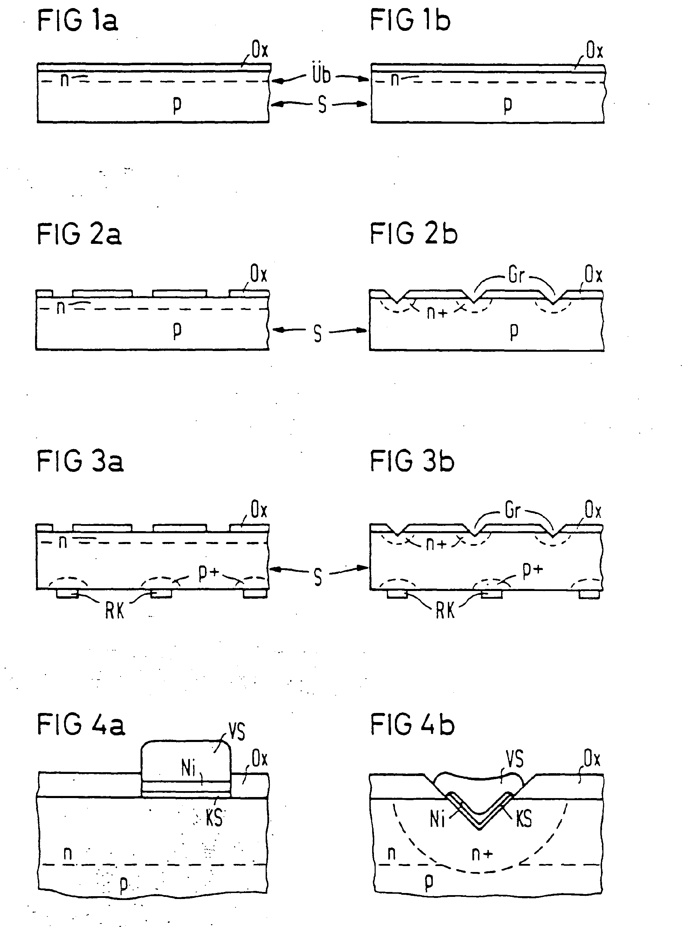

Im folgenden wird das Verfahren zur Herstellung der erfindungsgemäßen Solarzelle anhand von zwei Ausführungsbeispielen und der dazugehörigen Figuren 1a bis 4a die nicht das erfingungs gemäβe verfahren darstellen bzw. 1b bis 4b näher erläutert. Dabei zeigen die Figuren im schematischen Querschnitt verschiedene Verfahrensstufen.

### Ausführungsbeispiele.

Stellvertretend für verschiedene geeignete Solarzellentypen wird die Herstellung einer Solarzelle aus kristallinem Silizium beschrieben.

Figur 1: Als Ausgangsmaterial dient ein p-dotierter Cz-Wafer mit <100>-Orientierung. Durch eine basische kristallorientierte Ätzung wird zunächst auf der Oberfläche des Substrates S eine Texturierung erzeugt. Durch bevorzugtes Ätzen entlang bestimmter Kristallorientierungen entsteht so eine aufgerauhte Oberfläche mit pyramidenförmigen Erhebungen (in der Figur nicht dargestellt). In dieser als Frontseite der künftigen Solarzelle dienenden Oberfläche wird nun ein flacher pn-Übergang ÜB erzeugt, beispielsweise durch Eindiffusion von Phosphor P, wobei eine flache n-dotierte Zone n entsteht. Zur Passivierung der Oberfläche wird auf der Vorderseite eine Passivierungsschicht, zum Beispiel eine Oxidschicht OX erzeugt, die in der späteren Solarzelle gleichzeitig als Antireflexschicht dient. Den gleichen Zweck kann auch eine Siliziumnitridschicht oder eine aus beiden Materialien kombinierte Schicht erfüllen.

Als nächster Schritt erfolgt die Definierung und Erzeugung des Vorderseitenkontakts auf bzw. in der Oxidschicht OX. Dazu werden Gräben entsprechend der gewünschten Struktur der Metallisierung in der Oxidschicht OX erzeugt (siehe Figur 2a) und gegebenenfalls Gräben ins Silizium geätzt (siehe Figur 2b).

Eine strukturierte Öffnung im Oxid Ox kann zum Beispiel durch photolithographische und ätztechnische Prozesse erfolgen. Da-nach kann entweder in Planartechnik (Figur la bis 4a) oder nach der Erfindung in Grabentechnik (Figur 1b bis 4b) weitergearbeitet werden.

Figur 2b: Eine direkte Erzeugung der Gräben Gr gelingt durch Laserschreiben, wobei die Oxidschicht Ox und gegebenenfalls Silizium entlang der gewünschten Struktur mit einem Laser geeigneter Wellenlänge entfernt wird.

Ebenfalls möglich ist eine Erzeugung von Gräben Gr durch mechanisches Abtragen, zum Beispiel mit Hilfe eines diamantbesetzten Werkzeuges. Danach wird wieder wie bei der Laserstrukturierung weitergearbeitet.

Alternativ dazu kann ein Photolithographieschritt durchgeführt werden, bei dem zunächst ein positiv arbeitender Photoresist aufgebracht, gemäß der gewünschten Struktur belichtet und schließlich entwickelt wird. Die verbleibende Photoresiststruktur dient nun als Ätzmaske für die anschließende naßchemische Oxidöffnung, beispielsweise in einer flußsäurehaltigen Lösung.

Die Erzeugung von Gräben im Silizium gelingt in einer basischen Lösung mit dem verbleibenden Oxid als Ätzmaske. Für besonders dünne Wafer (Substrate) ist wegen der Bruchgefahr die Planartechnik (Figur la bis 4a) bevorzugt.

Im Ausführungsbeispiel beträgt die Breite der Gräben ca. 20 bis 50 µm, während der Abstand von einem Graben Gr zum benachbarten ca. 1 mm mißt.

Bei der Grabentechnik werden zur Verstärkung der n-Dotierung durch erneute Phosphordiffusion n⁺-dotierte Bereiche im Bereich der Gräben Gr erzeugt. Die Oxidschicht OX dient dabei als Maske. Die so erzeugte Anordnung ist in der Figur 2b dargestellt.

Figur 3a/3b: Im nächsten Verfahrensschritt wird der Rückseitenkontakt durch Aufdrucken einer leitfähigen Paste erzeugt. Besonders geeignet sind Siebdruckverfahren, wobei jedoch grundsätzlich auch andere Auftragsverfahren anwendbar sind. Geeignet sind beispielsweise Schablonendruck, Tampondruck, Pastenschreiben, Aufwalzen und ähnliche Verfahren. Die Paste selbst besitzt eine für das Aufdruckverfahren geeignete Viskosität und enthält neben oxidischen Komponenten als gut leitfähiges Metall, Silber. In der Paste ist noch der weiter Dotierstoff Aluminium enthalten, um einen besseren Rückseitenkontakt zu schaffen. Der Rückseitenkontakt RK kann ganzflächig aufgebracht werden. Ausreichend für eine gute Stromableitung ist jedoch eine kostensparende netzartige Struktur, wobei die Maschenweite bzw. der Abstand der aufgedruckten Leiterbahnen gröber gewählt ist als die Abstände der späteren Vorderseitenmetallisierung entsprechenden Grabenstruktur. Durch Einbrennen der aufgedruckten Struktur wird der zusätzliche Dotierstoff aluminium in das Substrat S eingetrieben, erzeugt dort p⁺-dotierte Zonen und schafft so einen guten elektrischen Kontakt zwischen dem Substrat S und dem Rückseitenkontakt RK.

Abschließend wird der Vorderseitenkontakt durch Metallisierung in den Gräben Gr erzeugt. Dazu wird zunächst eine Palladiumkeimschicht KS selektiv in den nitrid- bzw. oxidfreien Bereichen / der Oberfläche (Gräben) aus einer ionogenen Palladiumlösung abgeschieden. Durch chemische Abscheidung einer weiteren Schicht eines elektrisch gut leitenden Metalles wird die Keimschicht KS verstärkt. Zur Verstärkung geeignet ist zum Beispiel eine Nickel/Kupferdoppelschicht, wobei zunächst eine ca. 1 bis 5 µm, vorzugsweise ca. 2 µm dicke Nickelschicht Ni stromlos über der Keimschicht KS abgeschieden wird. Ebenfalls stromlos wird darüber eine 5 bis 20 µm dicke Kupferschicht VS erzeugt, die gegebenenfalls durch eine weitere dünne Schicht gegen Oxidation geschützt werden kann, beispielsweise durch einen dünnen Überzug aus Nickel, Silber oder Zinn.

Vorzugsweise wird die weitere verstärkende Schicht VS jedoch durch galvanische Abscheidung einer ca. 5 bis 20 µm dicken Silberschicht erzeugt. Dazu kann eine, ein Cyanid enthaltende Silbersalzlösung verwendet werden. Ebenfalls geeignet sind cyanidfreie Bäder, zum Beispiel auf der Basis von Silberchlorid und Natriumthiosulfat.

Figur 4 zeigt ausschnittsweise eine Oxidöffnung (Figur 4a), bzw. einen Graben mit darin abgeschiedener Vorderseitenmetallisierung. Der in Figur 4b dargestellte Graben weist hier einen v-förmigen Querschnitt auf, kann aber auch mit flachem Boden, also mit trapezförmigem oder rechteckigem Querschnitt erzeugt werden. Die Tiefe des Grabens beträgt hier ca. 15 µm, kann aber auch flacher oder tiefer ausgeführt sein. Für das Verfahren muß lediglich wie in den Figuren 1a bis 4a die Oberfläche des kristallinen Substrats S durch Entfernen des darüberliegenden Oxids OX oder Nitrids freigelegt werden. Bei Einhaltung der angegebenen Schichtdicken für die Vorderseitenkontakte und der Grabentiefe sind die Vorderseitenkontakte in die Oberfläche der Solarzelle versenkt. Möglich ist es auch, die Vorderseitenkontakte dicker auszuführen, so daß sie gegenüber der restlichen Oberfläche der Oxidschicht OX erhaben sind (siehe zum Beispiel Figur 4a).

Mit dem erfindungsgemäßen Verfahren gelingt es erstmals, einen fein strukturierten Vorderseitenkontakt mit Strukturbreiten bis 30 µm und ein einfaches Verfahren zur Herstellung des Rückseitenkontakte zu kombinieren. Die Erzeugung des Rückseitenkontakts ist zudem durch die dotierstoffhaltige Paste in einem einzigen Schritt auszuführen, wohingegen bekannte Verfahren einen Extraschritt zur Erzeugung der zusätzlichen Dotierung im Bereich des Rückseitenkontaktes erfordern.

Überraschend und neu ist es außerdem, daß der aufgedruckte Rückseitenkontakt die Metallisierungsschritte beim Erzeugen des Vorderseitenkontaktes unbeschadet übersteht und einen niederohmigen elektrischen Kontakt mit dem Substrat S bildet. Weder das fluoridionenhaltige Medium der Palladiumlösung, noch die hohe Temperatur und/oder die basischen bzw. sauren Metallisierungsbäder beeinträchtigen die Eigenschaften des Rückseitenkontakts und somit der gesamten Solarzelle. Der Rückseitenkontakt muß beim Verfahren nicht geschützt oder versiegelt werden.

Die Abscheidung bzw. Erzeugung des Vorderseitenkontaktes in Gräben ermöglicht eine größere Kontaktfläche zwischen Vorderseitenkontakt und Substrat und sorgt für eine bessere Haftung des Kontaktes auf der Oberfläche. Die Gräben Gr in der Passivierungsschicht OX erlauben außerdem eine gezielte n⁺-Dotierung im Bereich der Kontakte, so daß die Diffusionslängen für die Ladungsträger im restlichen kristallinen Substratmaterial eine ausreichende Länge behalten.

Mit den im Ausführungsbeispiel hergestellten Solarzellen werden Wirkungsgrade von über 16,5 Prozent erreicht.

Prinzipiell läßt sich das Verfahren auch bei Substraten aus polykristallinem Silizium oder anderen Halbleitermaterialien anwenden, wobei eine Anpassung verschiedener Verfahrensschritte erforderlich sein kann. Wesentlich ist jedoch stets die Kombination des Druckverfahrens für die Herstellung des Rückseitenkontakts mit der chemischen Abscheidung des Vorderseitenkontaktes, die zu den beschriebenen Vorteilen führt.

## Patentansprüche

1. Verfahren zur Herstellung von Vorder- und Rückseitenkontakten auf einer Solarzelle aus einem mono-oder polykristallinem Siliziumwafer (S) mit einem flachen p/n-Übergang (ÜB) und einer Passivierungsschicht (OX) auf der Vorderseite mit den Schritten
- Erzeugen einer Grabenstruktur (GR) in der Passivierungsschicht (OX),
- Erzeugen des Rückseitenkontaktes (RK) durch Aufdrucken und Einbrennen einer silberhaltigen Paste, die neben oxidischen Zuschlägen als Dotierstoff außerdem Aluminium enthält,
- Behandeln des Wafers (S) mit einer Fluoridionen enthaltenden ionogenen Palladiumlösung zur Erzeugung einer Keimschicht (KS) auf der im Grabenmuster (GR) freiliegenden Oberfläche des Wafers (S),
- Verstärken der Keimschicht (KS) durch chemische oder galvanische Abscheidung zumindest eines weiteren Metalls (VS) .

2. Verfahren nach Anspruch 1,
bei dem die Grabenstruktur photolithographisch definiert und durch naßchemisches Ätzen erzeugt wird.

3. Verfahren nach Anspruch 1,
bei dem die Grabenstruktur (GR) durch Laserschreiben erzeugt wird.

4. Verfahren nach Anspruch 1,
bei dem durch mechanischen Abtrag von Passivierungsschicht (OX) und von Silizium, und durch nachfolgendes Ätzen oder nachfolgender Laserstrukturierung die Grabenstruktur (GR) erzeugt wird.

5. Verfahren nach einem der Ansprüche 1 bis 4,
bei dem die Palladiumkeimschicht (KS) durch chemisches Abscheiden einer 1 bis 5 µm dicken Nickelschicht (Ni) und anschließend durch stromloses Abscheiden einer 5 bis 20µm dicken Kupferschicht (VS) verstärkt wird.

6. Verfahren nach einem der Ansprüche 1 bis 4,
bei dem die Palladiumkeimschicht (KS) durch Abscheidung einer 5 bis 20µm dicken Silberschicht (VS) verstärkt wird.

7. Verfahren nach einem der Ansprüche 1 bis 6,
bei dem ein Siliziumwafer (S) mit texturierter Oberfläche verwendet wird.

8. Verfahren nach einem der Ansprüche 1 bis 7,
bei dem der Rückseitenkontakt (RK) mittels Siebdruck in Form einer Netzstruktur auf der Rückseite des Wafers (S) aufgebracht wird.

## Claims

1. Process of producing front side and rear side contacts on a solar cell, made from a monocrystalline or polycrystalline silicon wafer (S) with a shallow p/n-transition (ÜB) and a passivation layer (OX) at the front side, comprising the steps of:'
- providing a trench structure (GR) in the passivation layer (OX),
- providing the rear side contact (RK) by imprinting and baking a silver-containing paste, said paste containing, in addition to oxidic components, also aluminum as a dopant,
- treating the wafer (S) with an ionogenic palladium solution containing fluoride ions to produce a seed layer (KS) on the free surface of the wafer (S) in the trench pattern (GR),
- strengthening the seed layer (KS) by chemical or galvanic deposition of at least one additional metal (VS).

2. Process according to claim 1, wherein the trench structure is defined by photolithography and produced by wet chemical etching.

3. Process according to claim 1, wherein the trench structure (GR) is produced by laser writing.

4. Process according to claim 1, wherein the trench structure (GR) is produced by mechanical removal of passivation layer (OX) and of silicon and by subsequent etching or subsequent laser structuring.

5. Process according to any of the claims 1 to 4, wherein the palladium seed layer (KS) is strengthened by chemical deposition of a nickel layer (Ni) having a thickness of 1 to 5 µm and subsequent by currentless deposition of a copper layer (VS) having a thickness of 5 to 20 µm.

6. Process according to any of the claims 1 to 4, wherein the palladium seed layer (KS) is strengthened by deposition of a silver layer (VS) having a thickness of 5 to 20 µm.

7. Process according to any of the claims 1 to 6, wherein a silicon wafer (S) having a textured surface is used.

8. Process according to any of the claims 1 to 7, wherein the rear side contact (RK) is applied to the rear side of the wafer (S) by screen printing in the form of a net structure.

## Revendications

1. Procédé de fabrication de contacts avant et arrière sur une cellule solaire d'une plaquette de silicium (S) mono- ou polycristalline avec une transition p/n plate (ÜB) et une couche de passivation (OX) sur le côté avant comprenant les étapes suivantes :
- réalisation d'une structure de trous (GR) dans la couche de passivation (OX) ;
- fabrication du contact arrière (RK) par impression et calcination d'une pâte contenant de l'argent qui contient, à côté d'additifs oxydiques encore de l'aluminium comme substance de dopage;
- traitement de la plaquette (S) avec une solution de palladium ionogène contenant des ions fluorure pour la production d'une couche à germe (KS) sur la surface libérée de la plaquette (S) dans l'échantillon troué (GR);
- renforcement de la couche à germe (KS) par dépôt chimique ou galvanique d'au moins un autre métal (VS).

2. Procédé selon la revendication 1, dans lequel la structure en trous est définie par photolithographie et est produite par attaque chimique au mouillé.

3. Procédé selon la revendication 1, dans lequel la structure en trous (GR) est produite par gravure laser.

4. Procédé selon la revendication 1, dans lequel la structure en trous (GR) est produite par enlèvement mécanique de la couche de passivation (OX) et du silicium, et par attaque chimique consécutive ou structuration au laser consécutive.

5. Procédé selon l'une des revendications 1 à 4, dans lequel la couche à germe de palladium (KS) est renforcée par dépôt chimique d'une couche de nickel (Ni) d'une épaisseur de 1 à 5 µm, puis par dépôt non conducteur d'une couche de cuivre (VS) d'une épaisseur de 5 à 20 µm.

6. Procédé selon l'une des revendications 1 à 4, dans lequel la couche à germe de palladium (KS) est renforcée par dépôt d'une couche d'argent (VS) de 5 à 20 µm.

7. Procédé selon l'une des revendications 1 à 6, dans lequel une plaquette de silicium (S) est utilisée avec une surface texturée.

8. Procédé selon l'une des revendications 1 à 7, dans lequel le contact arrière (RK) est appliqué par sérigraphie sous forme d'une structure réticulée à l'arrière de la plaquette (S).
